# EUROPEAN PATENT APPLICATION

(11) **EP 4 734 706 A1**
(43) Date of publication of application: **29.04.2026**
(21) Application number: 24916240.5
(22) Date of filing: 15.04.2024
(51) Int. Cl.: H10F 19/90

(54) **BACK-CONTACT SOLAR CELL STRING, CELL MODULE AND PHOTOVOLTAIC SYSTEM**

(30) Priority: 09.01.2024 CN 202420065535 U
(71) Applicant: Zhejiang Aiko Solar Energy Technology Co., Ltd., Yiwu, Jinhua Zhejiang 322000 (CN); Tianjin Aiko Solar Energy Technology Co., Ltd., Tianjin 300400 (CN); Zhuhai Fushan Aiko Solar Energy Technology Co., Ltd., FushanIndustrial Park, Doumen District Zhuhai Guangdong 519000 (CN); Guangdong Aiko Solar Energy Technology Co., Ltd., Foshan, Guangdong 528000 (CN); Shenzhen Aiko Digital Energy Technology Co., Ltd., Shenzhen, Guangdong 518000 (CN)
(72) Inventor: WANG, Yongqian, Jinhua, Zhejiang 322000 (CN); ZHANG, jianjun, Jinhua, Zhejiang 322000 (CN); YANG, Xinqiang, Jinhua, Zhejiang 322000 (CN); CHEN, Gang, Jinhua, Zhejiang 322000 (CN)
(74) Representative: EP&C
(86) International application number: PCT/CN2024/087774
(87) International publication number: WO 2025/148182

(57) **Abstract**

**This disclosure** is applicable to the technical field of solar cells, and provides a back contact solar cell string (100), a cell assembly (200), and a photovoltaic system (1000). In the back contact solar cell string (100), a spacing area (101) is formed between every two adjacent back contact solar cells (10). P-type doped layers (11) and N-type doped layers (12) of each back contact solar cell (10) are provided with first conductive connectors (20). The first conductive connectors (20) on the P-type doped layers (11) are fixed to and conductively connected with all the P-type doped layers (11) in each back contact solar cell (10). The first conductive connectors (20) on the N-type doped layers (12) are fixed to and conductively connected with all the N-type doped layers (11) in each back contact solar cell (10). Second conductive connectors (80) are arranged at the spacing areas (101), and are connected with all the first conductive connectors (20). At a position corresponding to the spacing area (101), a part of a Mth first conductive connector (20) located on one side of the second conductive connector (80) is cut off, and a part of an (M+1)^{th} first conductive connector (20) located on the other side of the second conductive connector (80) is cut off. The cut off first conductive connector (20) forms a suspended segment (21) in the spacing area (101) that is not connected with the second conductive connector (80), and a length (L1) of the suspended segment (21) is less than a distance (L2) between the two adjacent first conductive connectors (20).

## Description

### Priority Information

This disclosure claims the priority and benefits of the Patent Application No. 202420065535.6, filed with the China National Intellectual Property Administration on January 9, 2024, and the entire content of which is incorporated herein by reference.

### Technical Field

This disclosure relates to the technical field of solar cells, and in particular, to a back contact solar cell string, a cell assembly, and a photovoltaic system.

### Background

In the related art, when back contact solar cells form a cell string, fingers and busbars are typically formed on cell pieces using a patterning technology, and then cell piece cascading to form the cell string is achieved by welding ribbons on the busbars. In this technical solution, the busbars need to be additionally arranged to implement current collection, and then the ribbons are welded to the busbars to implement cell piece cascading, resulting in high costs.

To solve the technical problems, instead of arranging the busbars, a method that a wire is directly correspondingly arranged in a P-type area and an N-type area of each cell piece to make direct contact with the P-type area and the N-type area, and then every other wire is cut off is used to directly implement cascading of the cell pieces. However, in this technical solution, a part of the wire will suspend when the wire is cut off, and a suspension part is likely to bend and make contact with the adjacent wire, resulting in short circuits.

### Summary

This disclosure provides a back contact solar cell string, a cell assembly, and a photovoltaic system.

This disclosure is implemented as follows. The back contact solar cell string according to this embodiment of this disclosure includes:
a plurality of back contact solar cells arranged in a first direction, a back surface of each back contact solar cell including P-type doped layers and N-type doped layers, wherein the P-type doped layer and the N-type doped layer are sequentially arranged alternately in a second direction, the second direction intersecting with the first direction, a spacing area being arranged between every two adjacent back contact solar cells, a P-type doped layers of one of the two adjacent back contact solar cells corresponding to a P-type doped layers of an other one of the two adjacent back contact solar cells in the first direction, and an N-type doped layers of one of the two adjacent back contact solar cells also corresponding to an N-type doped layers of the other one of the two adjacent back contact solar cells in the first direction;
a plurality of first conductive connectors, the plurality of first conductive connectors being parallel to the P-type doped layers and the N-type doped layers and being arranged at intervals in the second direction, and the P-type doped layers and the N-type doped layers of each back contact solar cell being provided with the first conductive connectors; and
the first conductive connectors on the P-type doped layers being fixed to and conductively connected with all the corresponding P-type doped layers in each back contact solar cell in the first direction, and the first conductive connectors on the N-type doped layers being fixed to and conductively connected with all the corresponding N-type doped layers in each back contact solar cell in the first direction; and
a plurality of second conductive connectors, the plurality of second conductive connectors extending in the second direction, and each spacing area being correspondingly provided with one second conductive connector, and the plurality of second conductive connectors being connected with all the first conductive connectors; and
at a position corresponding to the spacing area, a part of a Mth first conductive connector located on one side of the second conductive connector being cut off, and a part of an (M+1)^{th} first conductive connector located on the other side of the second conductive connector being cut off, as to cascade the plurality of back contact solar cells to form the back contact solar cell string, and the M being a positive integer,
wherein a first conductive connector which is cut off forms a suspended segment in the spacing area that is not connected with the second conductive connector, and a length of the suspended segment is less than a distance between two adjacent first conductive connectors.

This disclosure further provides a cell assembly, including a plurality of back contact solar cell strings mentioned above.

This disclosure further provides a photovoltaic system, including the above cell assembly.

Additional aspects and advantages of this disclosure will be partially given in the following description, some of which will become apparent from the following description or can be learned from practices of this disclosure.

### Brief Description of the Drawings

Fig. 1 is a schematic diagram of a module of a photovoltaic system according to an embodiment of this disclosure;
Fig. 2 is a schematic diagram of a module of a cell assembly according to an embodiment of this disclosure;
Fig. 3 is a schematic diagram of a plane structure of a back contact solar cell string according to an embodiment of this disclosure;
Fig. 4 is a schematic diagram of another plane structure of a back contact solar cell string according to an embodiment of this disclosure;
Fig. 5 is a schematic diagram of yet another plane structure of a back contact solar cell string according to an embodiment of this disclosure;
Fig. 6 is a schematic diagram of still another plane structure of a back contact solar cell string according to an embodiment of this disclosure;
Fig. 7 is a schematic diagram of a cross section of a back contact solar cell string at a position of a first conductive connector in a first direction according to an embodiment of this disclosure;
Fig. 8 is a schematic diagram of another cross section of a back contact solar cell string at a position of a first conductive connector in a first direction according to an embodiment of this disclosure; and
Fig. 9 is a schematic diagram of yet another cross section of a back contact solar cell string at a position of a first conductive connector in a first direction according to an embodiment of this disclosure.

Descriptions of main component numerals:
1000-photovoltaic system, 200-cell assembly, 100-back contact solar cell string, 10-back contact solar cell, 11-P-type doped layer, 12-N-type doped layer, 101-spacing area, 20-first conductive connector, 21-suspension segment, 30-first current collecting ribbon, 40-second current collecting ribbon, 50-metal grid line, 60-first shielding layer, 70-insulation coating, and 80-second conductive connector.

### Detailed Description of the Embodiments

In order to provide a clearer understanding of the objectives, technical solutions, and advantages of this disclosure, this disclosure is further described in detail in conjunction with accompanying drawings and embodiments below. Examples of the embodiments are shown in accompanying drawings, where the same or similar elements or the elements having the same or similar functions are denoted by the same or similar reference numerals throughout the description. It should be noted that the embodiments described below with reference to the accompanying drawings are exemplary, are used only for explaining this disclosure, and should not be construed as a limitation on this disclosure. Additionally, it should be understood that the specific embodiments described herein are merely used for explaining this disclosure rather than limiting this disclosure.

In the description of this disclosure, it should be understood that orientation or position relationships indicated by the terms such as "upper", "lower", "left", "right", "transverse", and "longitudinal" are based on orientation or position relationships shown in the accompanying drawings, and are intended to facilitate the description of this disclosure and simplify the description only, rather than indicate or imply that a referred apparatus or element must have a particular orientation or must be constructed and operated in a particular orientation. Therefore, such terms should not be construed as a limitation on this disclosure.

Additionally, the terms "first" and "second" are used merely for the purpose of description, and should not be construed as indicating or implying relative importance or implying a quantity of indicated technical features. Therefore, features defined as "first" and "second" can explicitly or implicitly include one or more of the features. In the description of this disclosure, the meaning of "a plurality of" is two or more, unless otherwise explicitly and specifically defined.

In this disclosure, unless otherwise expressly specified and limited, a first feature being "above" or "below" a second feature can include direct contact of the first feature and the second feature, or can also include indirect contact of the first feature and the second feature through an additional feature therebetween. In addition, the first feature being "over", "above", and "on" the second feature includes the first feature being over and above the second feature, or merely indicates that a level of the first feature is higher than that of the second feature. The first feature being "under", "below", and "underneath" the second feature includes the first feature being under and below the second feature, or merely indicates that the level of the first feature is lower than that of the second feature.

The following disclosure provides multiple different embodiments or examples to implement different structures of this disclosure. To simplify this disclosure, components and settings in particular examples are described below. Certainly, they are merely examples and are not intended to limit this disclosure. Further, in this disclosure, reference numerals and/or reference letters can be repeated in different examples, and such repetition is for simplification and clarity purposes and does not indicate a relationship between the various embodiments and/or settings being discussed. In addition, this disclosure provides examples of various specific processes and materials, but those of ordinary skill in the art can realize the disclosure of other processes and/or disclosure scenarios of other materials.

### Embodiment 1

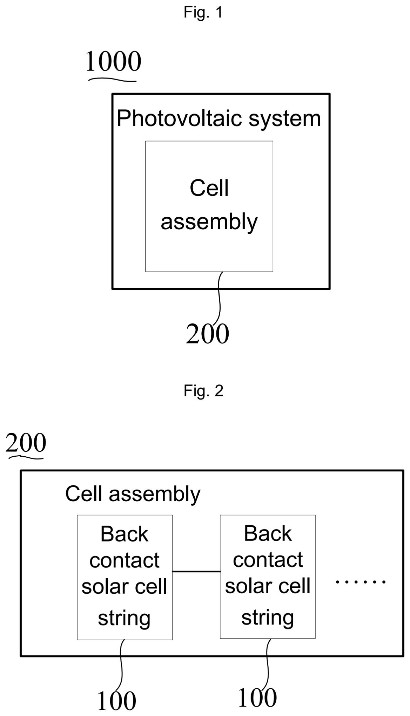

Referring to Fig. 1 and Fig. 2, a photovoltaic system 1000 in this embodiment of this disclosure can include a cell assembly 200 in this embodiment of this disclosure. The cell assembly 200 in this embodiment of this disclosure can include a plurality of back contact solar cell strings 100 in this embodiment of this disclosure.

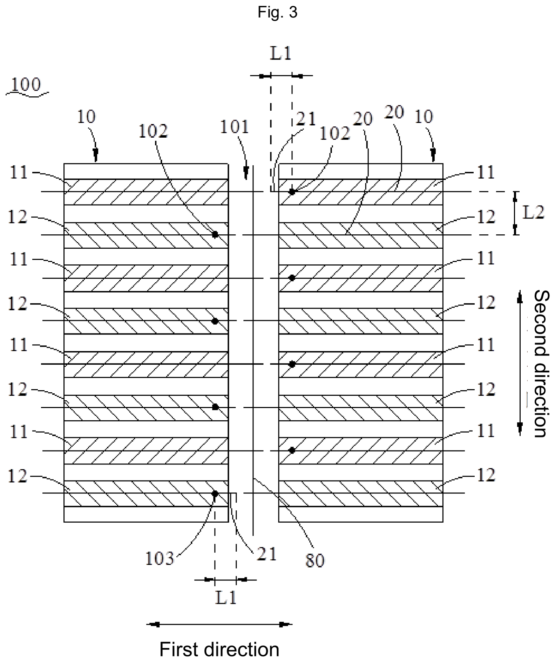

Referring to Fig. 3 to Fig. 6, the back contact solar cell string 100 in this embodiment of this disclosure can include a plurality of back contact solar cells 10, a plurality of first conductive connectors 20, and a plurality of second conductive connectors 80.

The plurality of back contact solar cells 10 can be arranged at intervals in a first direction. A back surface of each back contact solar cell 10 includes P-type doped layers 11 and N-type doped layers 12, wherein the P-type doped layer and the N-type doped layer are sequentially arranged alternately in a second direction, the P-type doped layers 11 and the N-type doped layers 12 extend in the first direction, and the first direction intersects with the second direction.

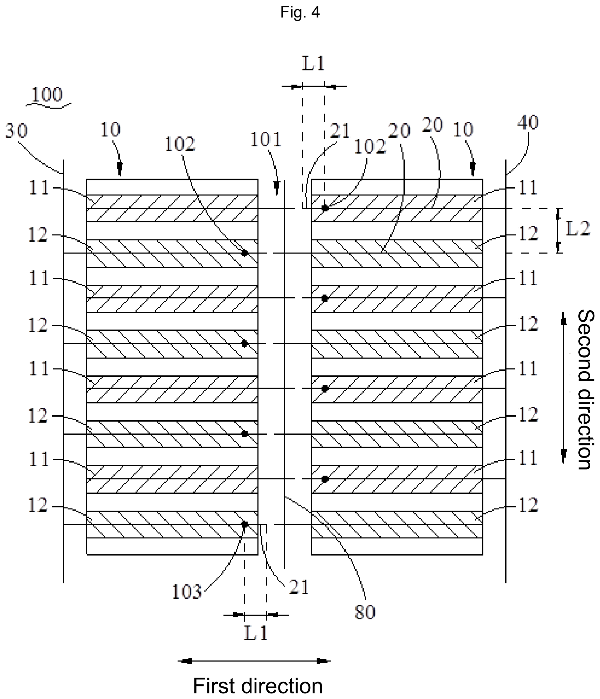

The first direction can be a cascading direction of the back contact solar cell string 100 (i.e., a transverse direction in Fig. 3), and the second direction can be a direction perpendicular to the cascading direction (i.e., a longitudinal direction in Fig. 4), with both directions being perpendicular to each other.

As shown in Fig. 3 to Fig. 6, a spacing area 101 is arranged between every two adjacent back contact solar cells 10. The P-type doped layers 11 of one of the two adjacent back contact solar cells 10 correspond to the P-type doped layers 11 of the other one of the two adjacent back contact solar cells 10 in the first direction, and the N-type doped layers 12 of one of the two adjacent back contact solar cells 10 also correspond to the N-type doped layers 11 of the other one of the two adjacent back contact solar cells 10 in the first direction.

That is, in the entire back contact solar cell string 100, arrangement methods of the P-type doped layers 11 and the N-type doped layers 12 in all the back contact solar cells 10 are the same. The P-type doped layers 11 of one back contact solar cell 10 of the two adjacent back contact solar cells 10 and the P-type doped layers 11 of the other one back contact solar cell 10 of the two adjacent back contact solar cells 10 are basically located on the same straight line in the first direction, and the N-type doped layers 12 of one back contact solar cell 10 of the two adjacent back contact solar cells 10 and the N-type doped layers 12 of the other one back contact solar cell 10 of the two adjacent back contact solar cells 10 are also basically located on the same straight line in the first direction.

The first conductive connectors 20 extend in the first direction and are arranged parallel to the P-type doped layers 11 and the N-type doped layers 12. The plurality of first conductive connectors 20 are arranged at intervals in the second direction.

The P-type doped layers 11 and the N-type doped layers 12 of each back contact solar cell 10 are provided with the first conductive connectors 20. The number of the first conductive connectors 20 is the same as the sum of the number of the P-type doped layers 11 and the number of the N-type doped layers 12 of each back contact solar cell 10.

The first conductive connectors 20 on the P-type doped layers 11 are fixed to and conductively connected with all the corresponding P-type doped layers 11 in each back contact solar cell 10 in the first direction. The first conductive connectors 20 on the N-type doped layers 12 are fixed to and conductively connected with all the corresponding N-type doped layers 12 in each back contact solar cell 10 in the first direction.

As shown in Fig. 3 to Fig. 7, the first conductive connectors 20 on the P-type doped layers 11 are sequentially connected with the corresponding P-type doped layers 11 in each back contact solar cell 10 in the first direction. The first conductive connectors 20 on the N-type doped layers 12 are sequentially connected with the corresponding N-type doped layers 12 in each back contact solar cell 10 in the first direction. That is, in the first direction, the P-type doped layers 11 of one back contact solar cell 10 of the two adjacent back contact solar cells 10 are connected with the P-type doped layers 11 of the other one back contact solar cell 10 of the two adjacent back contact solar cells 10 through the first conductive connectors 20, and the N-type doped layers 12 of one back contact solar cell 10 of the two adjacent back contact solar cells 10 are connected with the N-type doped layers 12 of the other one back contact solar cell 10 of the two adjacent back contact solar cells 10 through the first conductive connectors 20.

The second conductive connectors 80 extend in the second direction, and each spacing area 101 is correspondingly provided with one second conductive connector 80, and the second conductive connectors 80 are connected with all the first conductive connectors 20.

As shown in Fig. 3 to Fig. 7, at a position corresponding to the spacing area 101, a part of a Mth first conductive connector 20 located on one side of the second conductive connector 80 is cut off, and a part of the (M+1)^{th} first conductive connector 20 located on the other side of the second conductive connector 80 is cut off, thereby cascading the plurality of back contact solar cells 10 to form the back contact solar cell string 100, wherein M is a positive integer.

The first conductive connector 20 which is cut off forms a suspended segment 21 in the spacing area 101 that is not connected with the second conductive connector 80, and a length L1 of the suspended segment 21 is less than a distance L2 between two adjacent first conductive connectors 20.

For example, as shown in Fig. 3, the 1^{st} first conductive connector 20 is cut off on a left side of the second conductive connector 80, and the 2^{nd} first conductive connector 20 is cut off on a right side of the second conductive connector 80. Therefore, from top to bottom, the first conductive connectors 20 at odd positions are cut off on the left sides of the second conductive connectors 80, and the first conductive connectors 20 at even positions are cut off on the right sides of the second conductive connectors 80. That is, each first conductive connector 20 has one suspended segment 21, with the difference being that the suspension segments 21 of two adjacent first conductive connectors 20 are located on the left side of one second conductive connector 80 and the right side of the other second conductive connector 80.

It should be noted that as shown in Fig. 3, the first conductive connector 20 which is cut off forms two parts at the spacing area 101, one part is connected with the second conductive connector 80, and the other part is not connected with the second conductive connector 80. The suspended segment 21 refers to a part between an endpoint of the part in the first conductive connector which is cut off that is not connected with the second conductive connector 80 and a fixed point 102 between the part and the P-type doped layer 11 or the N-type doped layer that is closest to the spacing area 101 (i.e., an edge fixed point between the first conductive connector 20 and the P-type doped layer 11 and the N-type doped layer 12). The length L1 of the suspended segment 21 is a distance between the endpoint and the fixed point 102.

Meanwhile, it should also be noted that in this disclosure, " a distance between the two adjacent first conductive connectors 20" refers to a spacing between the two first conductive connectors 20 in the second direction, that is, a spacing between a lower edge of one first conductive connector 20 of the two adjacent first conductive connectors 20 and an upper edge of the other first conductive connector 20 of the two adjacent first conductive connectors 20.

In the back contact solar cell string 100, the cell assembly 200, and the photovoltaic system 1000 in this embodiment of this disclosure, the spacing area 101 is arranged between every two adjacent back contact solar cells 10 in the back contact solar cell string 100. The P-type doped layers 11 of one of the two adjacent back contact solar cells 10 correspond to the P-type doped layers 11 of the other one of the two adjacent back contact solar cells 10 in the first direction, and the N-type doped layers 12 of one of the two adjacent back contact solar cells 10 correspond to the N-type doped layers 11 of the other one of the two adjacent back contact solar cells 10 in the first direction. The plurality of first conductive connectors 20 are arranged at intervals in the second direction. The P-type doped layers 11 and the N-type doped layers of each back contact solar cell 10 are provided with the first conductive connectors 20. The number of the first conductive connectors 20 is the same as the sum of the number of the P-type doped layers 11 and the number of the N-type doped layers 12 of each back contact solar cell 10. The first conductive connectors 20 on the P-type doped layers 11 are fixed to and conductively connected with all the corresponding P-type doped layers 11 in each back contact solar cell 10 in the first direction. The first conductive connectors 20 on the N-type doped layers 12 are fixed to and conductively connected with all the corresponding N-type doped layers 12 in each back contact solar cell 10 in the first direction. At the position corresponding to the spacing area 101, the part of the M^{th} first conductive connector 20 located on one side of the second conductive connector 80 is cut off, and the part of the (M+1)^{th} first conductive connector 20 located on the other side of the second conductive connector 80 is cut off, thereby cascading the plurality of back contact solar cells 10 to form the back contact solar cell string 100, where M is the positive integer. The first conductive connector 20 which is cut off forms the suspended segment 21 in the spacing area 101 that is not connected with the second conductive connector 80, and the length L1 of the suspended segment 21 is less than the distance L2 between the two adjacent first conductive connectors 20.

Accordingly, by arranging the plurality of first conductive connectors 20 and the plurality of second conductive connectors 80 in the back contact solar cell string 100, the part of the M^{th} first conductive connector 20 which is cut off that is located on one side of the second conductive connector 80, the part of the (M+1)^{th} first conductive connector 20 which is cut off that is located on the other side of the second conductive connector 80, and all the back contact solar cells 10 can be directly cascaded to form the back contact solar cell string 100 by cutting off the first conductive connectors 20. The length L1 of the suspended segment 21 that is formed by the first conductive connector 20 which is cut off and does not make contact with the second conductive connector 80 is less than the distance L2 between the two adjacent first conductive connectors 20, to avoid a situation that the suspended segment 21 formed by the cut off first conductive connector 20 bends and makes contact with the adjacent first conductive connector 20, leading to electric leakage, thereby ensuring stability and reliability of the back contact solar cell string 100.

It should be understood that different from the prior art, which uses busbars to achieve current convergence and then connects the busbars through ribbons to form a cell string, this disclosure first directly connects each P-type doped layer 11 of one back contact solar cell 10 of the two adjacent back contact solar cells 10 to the corresponding P-type doped layer 11 of the other back contact solar cell 10 of the two adjacent back contact solar cells 10 by using the continuous first conductive connectors 20, directly connects each N-type doped layer 12 of one back contact solar cell 10 of the two adjacent back contact solar cells 10 to the corresponding N-type doped layer 12 of the other back contact solar cell 10 of the two adjacent back contact solar cells 10 by using the continuous first conductive connectors 20, then, sets the second conductive connector 80 that is electrically connected with the first conductive connector 20 in the spacing area 101 between the two back contact solar cells 10, and then cut off the first conductive connectors 20 through a truncation method as described above to form the back contact solar cell string 100.

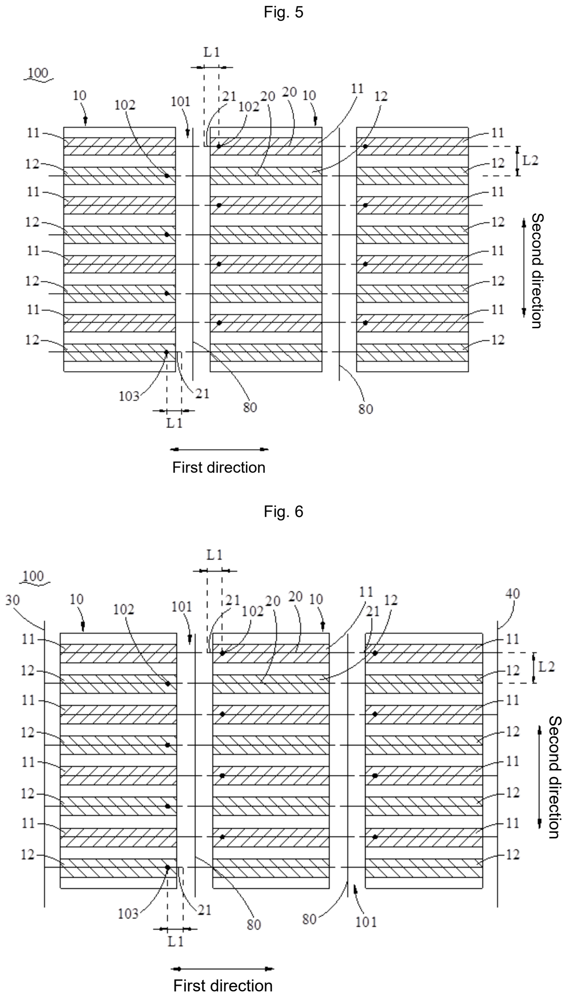

Referring to Fig. 5 and Fig. 6, in some embodiments, the number of the back contact solar cells 10 is greater than two, and one same first conductive connector 20 is cut off at the same position in the adjacent spacing areas 101.

In other words, if in the first spacing area 101, the part of the M^{th} first conductive connector 20 that is located on the right side of the second conductive connector 80 is cut off, and the part of the (M+1)^{th} first conductive connector 20 that is located on the left side of the second conductive connector 80 is cut off, in the second spacing area 101, the part of the M^{th} first conductive connector 20 that is located on the right side of the second conductive connector 80 is cut off, and the part of the (M+1)^{th} first conductive connector 20 that is located on the left side of the second conductive connector 80 is cut off.

For example, as shown in Fig. 5 and Fig. 6, in embodiments shown in Fig. 5 and Fig. 6, two spacing areas 101 exist. In the first spacing area 101, from top to bottom, the first conductive connectors 20 at the odd positions are cut off on the right side of the second conductive connectors 80, and the first conductive connectors 20 at the even positions are cut off on the left side of the second conductive connectors 80. Similarly, in the second spacing area, the first conductive connectors 20 at the odd positions are also cut off on the right side of the second conductive connectors 80, the first conductive connectors 20 at the even positions are cut off on the right side of the second conductive connectors 80, and so on.

Therefore, through the truncation method, smooth current collection can be achieved, to avoid short circuits.

As shown in Fig. 4 and Fig. 6, in this embodiment of this disclosure, the back contact solar cell string 100 further includes a first current collecting ribbon 30 and a second current collecting ribbon 40 which are located at two ends of the back contact solar cell string 100 respectively. In the plurality of first conductive connectors 20, every other first conductive connector 20 is electrically connected with the first current collecting ribbon 30 and the second current collecting ribbon 40, thereby achieving the current convergence and output of the back contact solar cell string 100.

It should be understood that in this embodiment of this disclosure, the cell assembly 200 can further include a metal frame, a backsheet, photovoltaic glass, and an encapsulation film (which are not shown in the figures). The encapsulation film, serving as a filler, can be filled between a front surface of the back contact solar cell 10 and the photovoltaic glass, between a back surface and the backsheet, as well as between adjacent cell pieces, which can be served as a transparent encapsulant with excellent light transmission and aging resistance properties. For example, the encapsulation film can be an ethylene vinyl acetate (EVA) encapsulation film or a polyolefin elastomer (POE) encapsulation film, which can be specifically selected according to actual situations and is not limited herein.

The photovoltaic glass can cover the encapsulation film on the front surface of the back contact solar cell 10, and can be ultra-white glass, which has a high light transmittance, high transparency, and superior physical, mechanical, and optical properties. For example, the ultra-white glass can have a light transmittance of 92% or above, and can protect the back contact solar cell 10 without affecting the efficiency of the back contact solar cell 10 as much as possible. Meanwhile, the encapsulation film can bond the photovoltaic glass and the back contact solar cell 10 together, and due to the existence of the encapsulation film, sealing, insulating, water proofing, and damp proofing can be performed on the back contact solar cell 10.

The backsheet can be attached to the encapsulation film on the back surface of the back contact solar cell 10, can protect and support the back contact solar cell 10, and has reliable insulation, water resistance, and aging resistance. There can be multiple selections for the backsheet, and the backsheet can be typically tempered glass, organic glass, am aluminum alloy TPT composite encapsulation film, etc., which can be specifically set according to specific situations, and is not limited herein. An assembly composed of the backsheet, the back contact solar cell 10, the encapsulation film, and the photovoltaic glass can be arranged on the metal frame. The metal frame serves as a main external support structure for the entire cell assembly 200, and can stably support and install the cell assembly 200. For example, the cell assembly 200 can be installed at a required installation position through the metal frame.

Further, in some embodiments, the photovoltaic system 1000 is applied to a photovoltaic power station, such as a surface power station, a rooftop power station, and a water surface power station, in some embodiments, the photovoltaic system 1000 is also be applied to a device or apparatus that generates electricity using solar energy, such as a user solar power supply, a solar streetlamp, a solar car, and a solar building. Certainly, it should be understood that application scenarios of the photovoltaic system 1000 are not limited to these. That is, the photovoltaic system 1000 can be applied to all fields where the solar energy needs to be used for power generation. Taking a photovoltaic power generation system as an embodiment, the photovoltaic system 1000 can include a photovoltaic array, a combiner box, and an inverter. The photovoltaic array can be an array combination of a plurality of cell assemblies 200. For example, the plurality of cell assemblies 200 can form a plurality of photovoltaic arrays, which are connected to the combiner box. The combiner box can converge currents generated by the photovoltaic arrays, and the converged current flows through the inverter to be converted into alternating current power required by a utility grid, and then is connected to a utility network to achieve solar power supply.

### Embodiment 2

In some embodiments, in the second direction, the distance L2 between the two adjacent first conductive connectors 20 can range from 0.3 mm to 1.2 mm.

Accordingly, the situation that the distance L2 between the two adjacent first conductive connectors 20 is too small, resulting in the small length of the suspended segment 21 which is cut off, and consequently the process difficulty during cutting off the first conductive connectors 20 is increased can be avoided; and the situation that the distance L2 between the two adjacent first conductive connectors 20 is too large, resulting in a reduced number of the first conductive connectors 20, and as a result, a carrier collection effect is reduced can be avoided as well.

Specifically, in such embodiments, the distance L2 between the two adjacent first conductive connectors 20 can be, for example, 0.3 mm, 0.4 mm, 0.5 mm, 0.6 mm, 0.7 mm, 0.8 mm, 0.9 mm, 1 mm, 1.1 mm, and 1.2 mm.

### Embodiment 3

In some embodiments, in the first direction, a distance (i.e., a width of the spacing area 101 in the first direction) between the two adjacent back contact solar cells 10 can range from 0.3 mm to 1.2 mm.

Accordingly, the inconvenient operation during cutting off the first conductive connectors 20 caused by the too small distance between the two adjacent back contact solar cells 10 can be avoided. The decrease in the number of the back contact solar cells 10 in the single back contact solar cell string 100 of the same size caused by the too large distance between the two adjacent back contact solar cells 10 can be avoided as well.

Specifically, in such embodiments, the distance the two adjacent back contact solar cells 10 can be, for example, 0.3 mm, 0.4 mm, 0.5 mm, 0.6 mm, 0.7 mm, 0.8 mm, 0.9 mm, 1 mm, 1.1 mm, and 1.2 mm.

### Embodiment 4

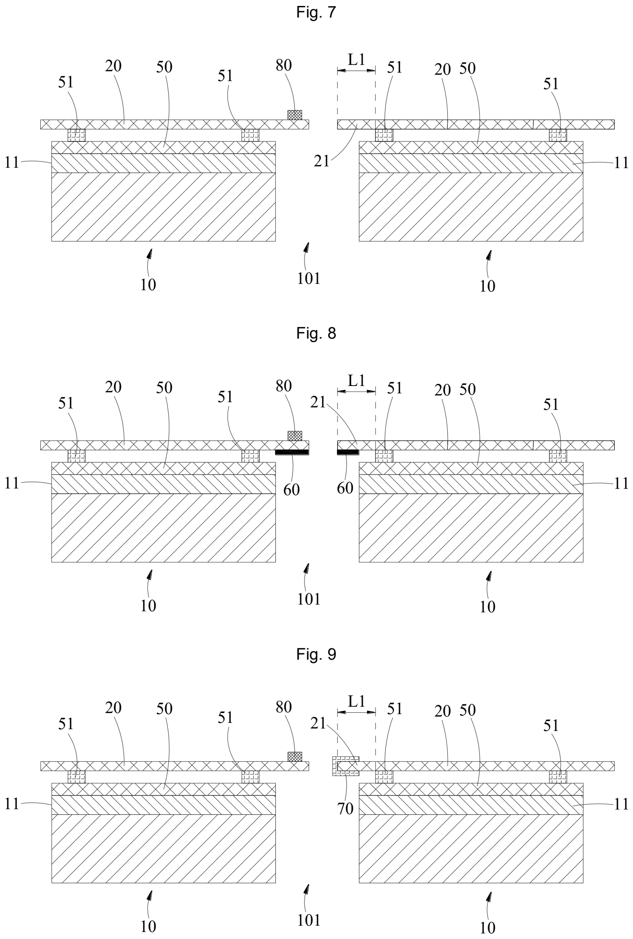

With reference to Fig. 7, in some embodiments, the back contact solar cell 10 further includes a plurality of metal grid lines 50 corresponding to the P-type doped layers 11 and the N-type doped layers 12. The metal grid lines 50 on the P-type doped layers 11 are in ohmic contact with the P-type doped layers 11, and the metal grid lines 50 on the N-type doped layers 12 are in ohmic contact with the N-type doped layers 12. The first conductive connectors 20 are fixedly connected with the metal grid lines 50.

A part between an endpoint of a part formed by the first conductive connector 20 which is cut off that is not connected with the second conductive connector 80 and the fixed point 102 between the part and the metal grid line 50 that is closest to the spacing area 101 is the suspended segment 21.

Accordingly, by welding the first conductive connectors 20 onto the metal grid lines 50, the connection stability and reliability of the first conductive connectors 20 can be improved, thereby effectively preventing the first conductive connectors 20 from falling off.

Specifically, in such embodiments, the metal grid lines 50 are metal finger electrodes. The metal grid lines 50 on the P-type doped layers 11 are P-type finger electrodes, and the metal grid lines 50 on the N-type doped layers 12 are N-type finger electrodes. The metal grid lines 50 are used to collect currents from a P-type area and an N-type area, and then the currents are connected in series through the first conductive connectors 20, and finally are converged and output through the first current collecting ribbon 30 and the second current collecting ribbon 40 described as above.

In such embodiments, the metal grid lines 50 can be formed on the P-type doped layers 11 and the N-type doped layers 12 through a printing and sintering method, and the first conductive connectors 20 can be connected with the metal grid lines 50 through a welding method. For example, as shown in Fig. 7, the metal grid line 50 can have a plurality of solder joints 51, and the conductive connector 20 can be welded to the metal grid line 50 through the solder joints 51. It is easy to understand that the solder joint 51 closest to the spacing area 101 is the fixed point 102 closest to the spacing area 101 mentioned herein.

In some embodiments, a length of the suspended segment 21 is less than a spacing between the first conductive connector 20 and the metal grid line 50 adjacent to the first conductive connector 20 in the second direction.

Accordingly, the suspended segment 21 can be prevented from bending and making contact with the adjacent metal grid line 50 of a different polarity.

Specifically, "a spacing between the first conductive connector 20 and the metal grid line 50 adjacent to the first conductive connector 20 in the second direction" refers to a distance between two opposite edges of the first conductive connector 20 and the metal grid line 50 in the second direction. It should be understood that in some embodiments, there can be a case that a width of the metal grid line 50 is greater than a width of the first conductive connector 20 in the second direction; and in this case, the first conductive connector 20 does not completely cover the metal grid line 50, and accordingly, to prevent the suspended segment 21 from bending and making contact with the edge of the adjacent metal grid line 50 and avoid a short circuit, the length of the suspended segment 21 can be set to be less than the spacing between the first conductive connector 20 and the adjacent metal grid line 50.

### Embodiment 5

Referring to Fig. 8, in some embodiments, at a corresponding position of the spacing area 101, one side of the first conductive connector 20 towards a light-receiving surface (i.e., a bottom surface in Fig. 8) of the back contact solar cell 10 is coated with a first shielding layer 60.

Accordingly, by coating an area of the first conductive connector 20 exposed from the spacing area 101 with the first shielding layer 60, the first conductive connector 20 can be shielded, thereby preventing the first conductive connector 20 from being directly exposed and affecting appearance.

Further, in such embodiments, the first shielding layer 60 and the back contact solar cell 10 can be the same in color. For example, when the back contact solar cell 10 is blue, the first shielding layer 60 can also be blue, and when the back contact solar cell 10 is golden, the first shielding layer 60 can also be golden.

Accordingly, by unifying the color of the first conductive connector 20 and the color of the back contact solar cell 10, the first conductive connector 20 of a different color can be prevented from being visible from a front surface at the spacing area 101, thereby ensuring aesthetic appeal.

In some embodiments, one side of the second conductive connector 80 towards the light-receiving surface of the back contact solar cell 10 is coated with a second shielding layer (not shown in the figure). Accordingly, by arranging the second shielding layer, the second conductive connector 80 is prevented from being directly exposed and affecting appearance.

In such embodiments, the second shielding layer and the back contact solar cell 10 can be the same in color.

### Embodiment 6

Referring to Fig. 9, in some embodiments, at a corresponding position of the spacing area 101, an end portion of the suspended segment 21 is coated with an insulation coating 70, and the insulation coating 70 wraps the end portion of the suspended segment 21.

Accordingly, by arranging the insulation coating 70, the situation that accidental cases occur after the first conductive connector 20 is cut off, causing conductive contact between two end portions formed after truncation is avoided, thereby improving the reliability of the back contact solar cell string 100.

Further, in such embodiments, the color of the insulation coating 70 corresponds to the color of the back contact solar cell 10. Accordingly, the aesthetic appeal of the entire back contact solar cell string 100 can be ensured.

In the descriptions of this specification, descriptions using reference terms "some embodiments", "an exemplary embodiment", "an example", "a specific example", or "some examples" mean that specific features, structures, materials, or characteristics described with reference to the embodiment or the example are included in at least one embodiment or example of this disclosure. In this specification, exemplary expressions of the above terms do not necessarily refer to the same embodiment or example. Moreover, the described specific features, structures, materials, or characteristics can be combined in a suitable manner in any one or more of the embodiments or examples.

Additionally, the foregoing descriptions are merely preferred embodiments of this disclosure, but are not intended to limit this disclosure. Any modification, equivalent substitution, improvement, etc. made within the spirit and principle of this disclosure shall fall within the scope of protection of this disclosure.

## Claims

1. A back contact solar cell string, comprising:
a plurality of back contact solar cells arranged in a first direction, a back surface of each back contact solar cell comprising P-type doped layers and N-type doped layers, wherein the P-type doped layer and the N-type doped layer are sequentially arranged alternately in a second direction, the second direction intersecting with the first direction, a spacing area being arranged between every two adjacent back contact solar cells, a P-type doped layer of one of the two adjacent back contact solar cells corresponding to a P-type doped layer of an other one of the two adjacent back contact solar cells in the first direction, and an N-type doped layer of one of the two adjacent back contact solar cells also corresponding to an N-type doped layer of the other one of the two adjacent back contact solar cells in the first direction;
a plurality of first conductive connectors, the plurality of first conductive connectors being parallel to the P-type doped layers and the N-type doped layers and being arranged at intervals in the second direction, and the P-type doped layers and the N-type doped layers of each back contact solar cell being provided with the first conductive connectors; and
the first conductive connectors on the P-type doped layers being fixed to and conductively connected with all the corresponding P-type doped layers in each back contact solar cell in the first direction, and the first conductive connectors on the N-type doped layers being fixed to and conductively connected with all the corresponding N-type doped layers in each back contact solar cell in the first direction; and
a plurality of second conductive connectors, the plurality of second conductive connectors extending in the second direction, and each spacing area being correspondingly provided with one second conductive connector, and the plurality of second conductive connectors being connected with all the first conductive connectors; and
at a position corresponding to the spacing area, a part of a Mth first conductive connector located on one side of the second conductive connector being cut off, and a part of an (M+1)^{th} first conductive connector located on an other side of the second conductive connector being cut off, as to cascade the plurality of back contact solar cells to form the back contact solar cell string, and the M being a positive integer,
wherein a first conductive connector which is cut off forms a suspended segment in the spacing area that is not connected with the second conductive connector, and a length of the suspended segment is less than a distance between two adjacent first conductive connectors.

2. The back contact solar cell string according to claim 1, wherein a number of the plurality of back contact solar cells is greater than two, and one same first conductive connector is cut off at a same position in two adjacent spacing areas.

3. The back contact solar cell string according to claim 1, wherein a distance between two adjacent first conductive connectors in the second direction ranges from 0.3 mm to 1.2 mm.

4. The back contact solar cell string according to claim 1, wherein a distance between the two adjacent back contact solar cells in the first direction ranges from 0.3 mm to 1.2 mm.

5. The back contact solar cell string according to claim 1, wherein the back contact solar cell further comprises a plurality of metal grid lines corresponding to the P-type doped layers and the N-type doped layers, the plurality of metal grid lines on the P-type doped layers are in ohmic contact with the P-type doped layers, the plurality of metal grid lines on the N-type doped layers are in ohmic contact with the N-type doped layers, and the plurality of first conductive connectors are fixedly connected with the metal grid lines.

6. The cell string according to claim 5, wherein the length of the suspended segment is less than a spacing between the first conductive connector and the metal grid line adjacent to the first conductive connector in the second direction.

7. The back contact solar cell string according to claim 1, wherein at the corresponding position of the spacing area, a side of the first conductive connector towards a light-receiving surface of the back contact solar cell is provided with a first shielding layer, and the first shielding layer corresponds to the back contact solar cell in color; and/or,
a side of the second conductive connector towards the light-receiving surface of the back contact solar cell is provided with a second shielding layer, and the second shielding layer corresponds to the back contact solar cell in color.

8. The back contact solar cell string according to claim 1, wherein an end portion of the suspended segment is coated with an insulation coating, and the insulation coating wraps the end portion of the suspension segment.

9. The back contact solar cell string according to claim 8, wherein the insulation coating corresponds to the back contact solar cell in color.

10. A cell assembly, comprising a plurality of back contact solar cell strings according to any one of claims 1 to 9.

11. A photovoltaic system, comprising the cell assembly according to claim 10.
